Europäisches Patentamt

European Patent Office

Office européen des brevets

(11) Veröffentlichungsnummer: **0 308 603**
**A1**

## (12) EUROPÄISCHE PATENTANMELDUNG

(21) Anmeldenummer: **88111256.9**

(22) Anmeldetag: **13.07.88**

(51) Int. Cl.4: **H01S 3/18** , **H01S 3/08** , **H01S 3/133**

(30) Priorität: **25.09.87 DE 3732409**

(43) Veröffentlichungstag der Anmeldung:
**29.03.89 Patentblatt 89/13**

(84) Benannte Vertragsstaaten:
**DE FR GB**

(71) Anmelder: **Siemens Aktiengesellschaft Berlin und München**
**Wittelsbacherplatz 2**
**D-8000 München 2(DE)**

(72) Erfinder: **Althaus, Hans-Ludwig, Dr.**
**Heinrich-Heine-Strasse 11**
**D-8411 Lappersdorf(DE)**
Erfinder: **Hörmann, Ewald, Dipl.-Ing.**
**Krankenhausstrasse 2c**
**D-8150 Holzkirchen(DE)**
Erfinder: **Keil, Rudolf, Dr.**
**Pulverturmstrasse 27a**
**D-8000 München 45(DE)**
Erfinder: **Klement, Ekkehard, Dr.**
**Akilindastrasse 31**
**D-8032 Gräfelfing(DE)**

(54) **Dynamisch einmodiger Lasersender.**

(57) Es soll ein dynamisch einmodiger Lasersender in Form eines Multimode-Halbleiterlasers (1) mit einem externen Resonator in Form eines gegenüber einer Laserlicht (20) emittierenden Austrittsfläche (12) des Lasers (1) angeordneten Spiegel (21) angegeben werden, der einfach herstellbar und dabei kompakt und stabil, insbesondere temperaturstabil ist.

Dazu ist der Spiegel (21) auf einer Endfläche (22) eines Metallstücks (2) ausgebildet, das zusammen mit dem Halbleiterlaser (1) auf einem gemeinsamen Trägerkörper (3) fixiert ist.

Optische Nachrichtentechnik, Breitbandsysteme

FIG 1

EP 0 308 603 A1

## Dynamisch einmodiger Lasersender

Die Erfindung betrifft einen dynamisch einmodigen Lasersender nach dem Oberbegriff des Patentanspruchs 1.

Für optische Nachrichtenübertragungssysteme mit großem Bandbreitenlängenprodukt, bei denen die Wellenlänge außerhalb des Disperionsminimums der Faser liegt, werden Lasersender benötigt, die auch dynamisch einmodig sind, d.h. bei Modulation nur in einem longitudinalen Modus schwingen. Derartige dynamisch einmodige Lasersender werden auch als DSM-Lasersender bezeichnet.

DSM-Lasersender können z.B. mit DFB-Lasern (siehe Electron. Lett. 17 (1981) S. 961-963), DBR-Lasern (siehe Electron. Lett. 18 (1982) S. 410-411), sog. C³-Lasern (siehe Electron. Lett. 19 (1983) S. 415-417) gekoppelten Laserarrays (siehe SFEB 14 (1985) S. 289-294) oder auch durch Ankopplung eines kurzen externen Resonators an eine multimodige Laserdiode aufgebaut werden. Bei einem DSM-Lasersender mit kurzem externem Resonator wird vor einer der beiden Austrittsflächen der Laserdiode ein zusätzlicher Spiegel angebracht, der das Licht in den Laser zurückreflektiert. Der externe Resonator wird dann durch diesen Spiegel und diese eine Austrittsfläche gebildet. Da der von der Laserdiode emittierte Laserstrahl im allgemeinen stark divergiert, ist die Rückreflexion in den Lasermodus mit einem planen Spiegel relativ gering. Um die Güte zu erhöhen, wird daher meist ein sphärischer Spiegel (siehe Opt. Commun. 13 (1975) S. 130-132; 11th Europ. Conf. on Opt. Comm. 1985, Venedig) oder auch eine Kollimationsoptik verwendet (siehe Opt. Fiber Comm., Jan. 1984, New Orleans).

DSM-Lasersender mit externem Resonator weisen den Vorteil auf, daß verglichen mit DFB-Lasern relativ einfache und damit billige Multimode-Laser, beispielsweise MCRW-Laser, verwendet werden können, die leicht erhältlich sind.

Schwierigkeiten bestehen in der hybriden Anordnung des Halbleiterlasers mit dem angekoppelten Resonator, die auf ca. 0,1 μm mechanisch zueinander stabil sein müssen.

Aufgabe der Erfindung ist es, einen Lasersender der eingangs genannten Art anzugeben, der einfach herstellbar und dabei kompakt und stabil ist.

Diese Aufgabe wird durch die im kennzeichnenden Teil des Patentanspruchs 1 angegebenen Merkmale gelöst.

Eine erste vorteilhafte Ausführungsvariante des erfindungsgemäßen Lasers ist im Anspruch 2 angegeben.

Einen relativ hohen Reflexionsgrad des Spiegels bei dieser ersten Variante erreicht man durch die im Anspruch 3 angegebenen Merkmale, wobei die Goldbeschichtung durch Bedampfung des Metallstücks aufgebracht werden kann.

Bei geringeren Anforderungen kann gemäß Anspruch 4 das Metallstück aus Pt-Rh bestehen, das nicht beschichtet oder bedampft ist.

Bei dieser ersten Variante sollte der Krümmungsradius der nach innen gewölbten Endfläche gemäß Anspruch 5 gleich dem 0,3- bis 0,5-fachen der optischen Länge des Lasers, vorzugsweise gleich dem 0,4-fachen dieser Länge sein. Unter der optischen Länge des Lasers ist das Produkt n·L aus der Brechzahl n im Laser und der geometrischen Länge L des Lasers zu verstehen.

Eine Monitordiode zur Überwachung der Ausgangsleistung des Halbleiterlasers könnte bei dem erfindungsgemäßen Lasersender knapp neben oder über dem Spiegel angebracht werden, so daß ein Teil des vom Spiegel reflektierten Lichts detektiert und zur Leistungsregelung des Lasers verwendet werden kann.

Eine vorteilhafte zweite Ausführungsvariante des erfindungsgemäßen Lasersenders, die eine Monitordiode aufweist, ist im Anspruch 6 angegeben. Bei dieser zweiten Variante wird die als Monitordiode verwendete Diode zugleich als Spiegel verwendet. Dazu genügt vielfach eine nichtentspiegelte Diode.

Zur Erhöhung der Rückreflexion durch die Diode kann die im Anspruch 7 angegebene Maßnahme ergriffen werden.

Generell ist bei dem erfindungsgemäßen Lasersender das Metallstück ein Stück Draht, wobei auf einer Stirnfläche dieses Stücks der Spiegel ausgebildet ist (Anspruch 8). Das Stück Draht kann kurz sein. Vorzugsweise hat das Stück Draht gemäß Anspruch 9 einen Durchmesser von 0,4 bis 0,6 mm, beispielsweise von 0,5 mm.

In Bezug auf die kompakte und stabile, insbesondere temperaturstabile Herstellung sind die im Anspruch 10 angegebenen Merkmale vorteilhaft, wobei es zweckmäßig ist, den erfindungsgemäßen Laser so zu gestalten, wie es Anspruch 11 und insbesondere im Anspruch 12 angegeben ist.

Anspruch 13 gibt eine vorteilhafte Weiterbildung des erfindungsgemäßen Lasersenders an, die insbesondere so ausgebildet sein kann, wie es im Anspruch 14 angegeben ist. Diese Weiterbildung ist besonders zur Herstellung von Sendemodulen mit dynamisch einmodigem Laser (DSM-Laser) und angekoppelter Monomodefaser geeignet.

Ein Verfahren zur Herstellung des erfindungsgemäßen Senders ist im Anspruch 15 angegeben.

Ein vorteilhaftes Verfahren zur Herstellung eines Spiegels in Form einer nach innen gewölbten Endfläche des Metallstücks und eine bevorzugte Ausgestaltung dieses Verfahrens ist im Anspruch 16 bzw. Anspruch 17 angegeben.

Die Erfindung wird anhand der Figuren in der folgenden Beschreibung beispielhaft näher erläutert. Von den Figuren zeigen:

Figur 1 eine Seitenansicht eines Lasersenders mit einem externen Resonator in Form eines Hohlspiegels an der Stirnfläche eines kurzen und im Schnitt gezeigten Stücks Metalldraht,

Figur 2 in Seitenansicht einen Sendemodul mit einem Fasertaper und einem in Figur 1 dargestellten Lasersender, und

Figur 3 eine Seitenansicht auf einen Lasersender mit einer auf einer Stirnfläche eines kurzen Stücks Metalldraht fixierten, nichtentspiegelten Diode, die den externen Resonator und zugleich eine Monitordiode bildet.

Die Figuren sind nicht maßstäblich.

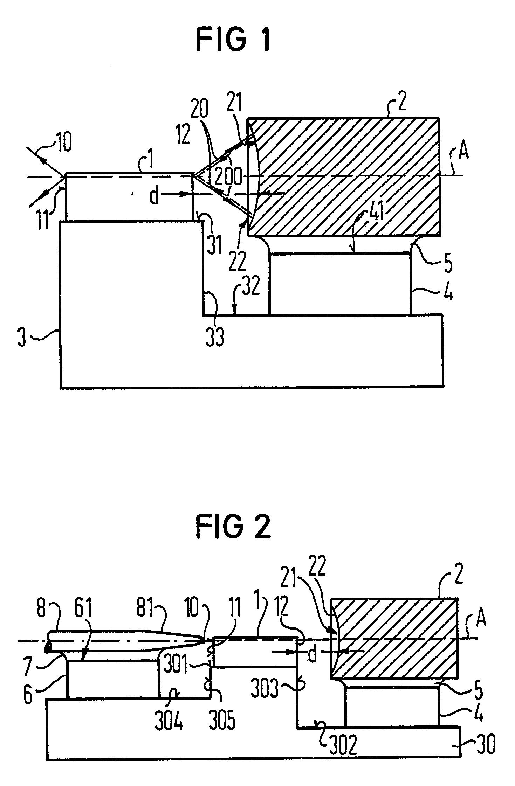

Beim Sender nach Figur 1 weist der Trägerkörper 3 eine Stufe 33 auf, die eine höherliegende Fixierungsfläche 31 des Trägerkörpers 3 von einer tieferliegenden Fixierungsfläche 32 dieses Körpers trennt. Auf der höherliegenden Fixierungsfläche 31 ist der Halbleiterlaser (1) und auf der tieferliegenden Fixierungsfläche 32 der Block 4 fixiert, der aus Quarzglas oder einem anderen Material besteht, das gegenüber dem Material des Trägerkörpers 3 eine schlechtere Wärmeleitfähigkeit hat. Der Block 4 sollte aus einem möglichst schlecht wärmeleitfähigen Material und der Trägerkörper 3 aus gut wärmeleitfähigem Material bestehen, beispielsweise aus Metall.

Auf dem Block 4 ist das kurze Stück Draht 2 aus Metall so fixiert, daß seine den Hohlspiegel 21 bildende, nach innen gewölbte und polierte Stirnfläche 22 der einen Austrittsfläche 12 des Lasers 1 gegenüberliegt, aus welcher Laserlicht 20 divergent austritt. Bei richtiger Fixierung des Stücks Draht 2 auf der optischen Achse A des Lasers 1 reflektiert der Hohlspiegel 21 das Laserlicht 20 in einem konvergenten Strahl 200 zum Laser zurück.

Das Stück Draht 2 ist mittels Lot 5 auf der vom Trägerkörper 3 abgekehrten Oberfläche 41 des Blocks 4 aus Quarzglas fixiert. Dazu ist diese Oberfläche 41 mit einer Metallisierung versehen, die sich mit dem Lot 5 verbindet.

Das aus der von der einen Austrittsfläche 12 abgekehrten anderen Austrittsfläche 11 emittierte Laserlicht 10 ist das vom Sender abgestrahlte Licht.

Der Sender nach Figur 1 läßt sich zu einem Sendemodul erweitern, der beispielhaft in Figur 2 dargestellt ist. Bei diesem Sendemodul weist der Trägerkörper 30 eine Stufe 303 und eine weitere Stufe 305 auf. Die Stufe 303 trennt eine höherliegende Fixierungsfläche 301 des Trägerkörpers 30 von einer tieferliegenden Fixierungsfläche 302 dieses Körpers. Diese Stufe 303 und diese Fixierungsflächen 301 und 302 entsprechen der Stufe 33 und den Fixierungsflächen 31 bzw. 32 des Trägerkörpers 3 nach Figur 1. Die weitere Stufe 305 ist auf der Seite der anderen Austrittsfläche des Lasers 1 angeordnet, und trennt die höherliegende Fixierungsfläche 301 einer weiteren tieferliegenden Fixierungsfläche 304. Auf dieser weiteren Fixierungsfläche 304 ist ein weiterer Block 6 aus Quarzglas oder einem anderen Material fixiert, das gegenüber dem Material des Trägerkörpers 30 eine höhere Wärmeleitfähigkeit aufweist. Auch der Block 6 sollte aus einem möglichst schlecht wärmeleitfähigem Material und der Trägerkörper 30 aus gut wärmeleitfähigem Material bestehen, beispielsweise aus Metall.

Der Endabschnitt 8 ist mittels Lot 7 an dem Block 6 in einer Weise fixiert, wie sie aus der europäischen Patentanmeldung mit der Veröffentlichungsnummer 0 204 224 hervorgeht.

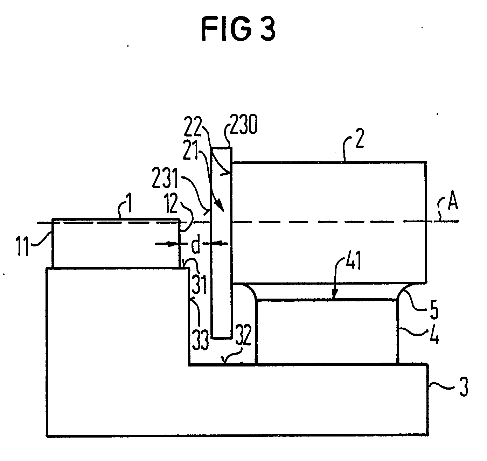

Der Sender nach Figur 3 unterscheidet sich vom Sender nach Figur 1 nur dadurch, daß der Spiegel 21 nicht aus einem Hohlspiegel, sondern aus einer auf der Stirnfläche 22 des Stücks Draht 2 aus Metall fixierten Photodiode 230 besteht, wobei die der einen Austrittsfläche 12 des Lasers 1 zugekehrte Lichtempfangsfläche 231 dieser Diode 230 nicht entspiegelt ist und damit reflektiert.

Durch die Ankopplung des externen Resonators in Form des Spiegels 21 sinkt der Schwellwert des Halbleiterlasers 1 um so stärker ab, je größer die Rückreflexion des Lichts von dem Spiegel 21 in den Laser 1 ist. Bei konstant gehaltenem Laserstrom kann daher der Anstieg der aus der anderen Austrittsfläche 11 austretenden Lichtleistung als einfaches Justierkriterium für den Spiegel 21 verwendet werden.

Zum Positionieren und Anlöten des Stücks Draht 2 wird dieses Stück mit einer justierbaren Pinzette mit zwei Klemmbacken aus hochohmigem Material gehalten. Legt man eine elektrische Spannung an die beiden Pinzettenarme und schließt den Stromkreis über die Klemmbacken und das Stück Draht 2, so kann der Draht auf die Löttemperatur erwärmt werden. Der Spiegel 21 kann dann vor dem Laser 1 justiert und nach Abschalten des Stromes fixiert werden. Durch den großen thermischen Widerstand des Blocks 4 und durch Kühlen des Trägerkörpers 3 bzw. 30 wird verhindert, daß sich der Halbleiterlaser 1 während des Lötvorgangs zu stark erwärmt.

Auf ähnliche Weise wird die Lötung des Endabschnitts 8 in dem Lasermodul nach Figur 2 vorgenommen, die aus der europäischen Patentanmeldung mit der Veröffentlichungsnummmer 0 204 224 bekannt ist.

Der als Hohlspiegel ausgebildete Spiegel 21 in den Figuren 1 und 2 kann durch Eindrücken einer kommerziell erhältlichen Mikrokugel, beispielsweise aus Saphir, in die Stirnfläche des Stücks 2 erzeugt werden.

In einem Ausführungsbeispiel wurde ein Stück aus einem polierten Pt-Rh-Draht mit eingedrücktem Hohlspiegel von 0,5 mm Radius in Bezug auf eine MCRW-Laserdiode mit einer Emissionswellenlänge $\lambda$ = 1,3 $\mu$m justiert und auf dem Trägerkörper 3 festgelötet. Die Seitenmodenunterdrückung betrug dabei etwa 24 dB. Im Cw-Betrieb blieb diese Seitenmodenunterdrückung in einem Temperaturbereich von ca. 10°C stabil.

## Ansprüche

1. Dynamisch einmodiger Lasersender in Form eines Multimode-Halbleiterlasers (1) mit einem externen Resonator in Form eines mit Abstand (d) gegenüber einer Laserlicht (20) emittierenden Austrittsfläche (12) des Lasers (1) angeordneten Spiegels (21), der das von dieser Austrittsfläche (12) divergent emittierte Laserlicht (20) zum Laser zurückreflektiert, **dadurch gekennzeichnet,** daß der Spiegel (21) auf einer Endfläche (22) eines Metallstücks (2) ausgebildet ist, das zusammen mit dem Halbleiterlaser (1) auf einem gemeinsamen Trägerkörper (3, 30) fixiert ist.

2. Sender nach Anspruch 1, **dadurch gekennzeichnet,** daß der Spiegel (21) aus der nach innen gewölbten und polierten Endfläche (22) des Metallstücks (2) besteht, die das von der einen Austrittsfläche (12) des Lasers (1) emittierte Laserlicht (20) in einem konvergenten Strahl (200) zum Laser (1) zurückreflektiert.

3. Sender nach Anspruch 2, **dadurch gekennzeichnet,** daß das Metallstück (2) aus Kupfer besteht und daß die Endfläche (22) dieses Stücks (2) mit Gold beschichtet ist.

4. Sender nach Anspruch 2, **dadurch gekennzeichnet,** daß das Metallstück (2) aus Pt-Rh besteht.

5. Sender nach einem der Ansprüche 2 bis 4, **dadurch gekennzeichnet,** daß der Krümmungsradius der nach innen gewölbten Endfläche (22) gleich dem 0,3- bis 0,5-fachen der optischen Länge des Lasers (1) ist.

6. Sender nach Anspruch 1, **dadurch gekennzeichnet,** daß der Spiegel (21) aus einer auf der Endfläche (22) des Metallstücks (2) fixierten Photodiode (230) besteht, wobei eine der einen Austrittsfläche (12) des Lasers (1) zugekehrte Lichtempfangsfläche der Diode (230) reflektiert.

7. Sender nach Anspruch 6, **dadurch gekennzeichnet,** daß die der einen Austrittsfläche (12) des Lasers (1) zugekehrte Seite (231) der Photodiode (23) mit einer dielektrischen Spiegelschicht (232) beschichtet ist.

8. Sender nach einem der vorhergehenden Ansprüche, **dadurch gekennzeichnet,** daß das Metallstück (2) ein Stück Draht ist, wobei auf einer Stirnfläche (22) dieses Stücks der Spiegel (21; 23) ausgebildet ist.

9. Sender nach Anspruch 8, **dadurch gekennzeichnet,** daß das Stück Draht einen Durchmesser von etwa 0,4 bis 0,6 mm hat.

10. Sender nach einem der vorhergehenden Ansprüche, **dadurch gekennzeichnet,** daß der Halbleiterlaser (1) direkt auf dem Trägerkörper (3; 30) und das Metallstück (2) auf einem Block (4) aus einem Material mit im Vergleich zum Material des Trägerkörpers (3; 30) schlechterer Wärmeleitfähigkeit fixiert ist, der auf dem Trägerkörper (3; 30) fixiert ist.

11. Sender nach Anspruch 10, **dadurch gekennzeichnet,** daß der Trägerkörper (3; 30) eine Stufe (33; 303) aufweist, die eine höherliegende Fixierungsfläche (31; 301) des Trägerkörpers (3; 30) von einer tieferliegenden Fixierungsfläche (32; 302) dieses Körpers trennt, und daß auf der höherliegenden Fixierungsfläche (31; 301) der Halbleiterlaser (1) und auf der tieferliegenden Fixierungsfläche (32; 302) der Block (4) aus dem relativ schlechter wärmeleitfähigen Material fixiert ist.

12. Sender nach Anspruch 10 oder 11, **dadurch gekennzeichnet,** daß der Block (4) aus dem relativ schlechter wärmeleitfähigen Material aus Quarzglas besteht und daß die Oberfläche (41) des Blocks (4), auf der das Metallstück (2) fixiert ist, eine Metallisierung aufweist.

13. Sender nach einem der vorhergehenden Ansprüche, **dadurch gekennzeichnet,** daß der Trägerkörper (30) auf einer von der einen Austrittsfläche (12) des Halbleiterlasers (1) abgekehrten und Laserlicht (10) emittierenden anderen Austrittsfläche (11) des Lasers (1) eine weitere Stufe (305) aufweist, welche die höherliegende Fixierungsfläche (301) von einer weiteren tieferliegenden Fixierungsfläche (304) trennt, die auf der Seite der anderen Austrittsfläche (11) angeordnet ist und auf der ein weiterer Block (6) aus einem im Vergleich zum Material des Trägerkörpers (30) schlechter wärmeleitfähigen Material fixiert ist, und daß auf diesem weiteren Block (6) gegenüber der anderen Austrittsfläche (11) des Lasers (1) ein Endabschnitt (8) einer Faser fixiert ist, in den das von der anderen Austrittsfläche (11) divergent emittierte Laserlicht (10) einkoppelbar ist.

14. Sender nach Anspruch 13, **dadurch gekennzeichnet,** daß der Endabschnitt (8) der Faser einen Fasertaper (8) aufweist.

15. Verfahren zur Herstellung eines Senders nach einem der vorhergehenden Ansprüche, **dadurch gekennzeichnet,** daß der Halbleiterlaser (1) und der Block (4) aus dem relativ schlechter wärmeleitfähigen Material auf dem Trägerkörper (3, 30) und das Metallstück (2) mit dem darauf ausgebildeten Spiegel (21, 23) auf dem Block (4) fixiert werden, und daß das Metallstück (2) mittels Lot (5) auf dem metallischen Block (4) fixiert wird.

16. Verfahren zur Herstellung eines Spiegels (21) in Form einer nach innen gewölbten Endfläche (22) des Metallstücks (2), **dadurch gekennzeichnet,** daß in die polierte Endfläche (22) des Metallstücks (2) eine Kugel aus härterem Material eingedrückt wird.

17. Verfahren nach Anspruch 16, **dadurch gekennzeichnet,** daß eine Kugel aus Saphir eingedrückt wird.

# FIG 1

# FIG 2

# FIG 3

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| | **EINSCHLÄGIGE DOKUMENTE** | | EP 88111256.9 |
| X | EP - A2/A3 - 0 140 820 (HERTZ) | 1,2,5, 8,16 | H 01 S 3/18 |
| A | * Fig. 1,2; Seite 3, Zeile 2 - Seite 4, Zeile 24; Seite 7, Zeile 8 - Seite 9, Zeile 23 * | 10,11 | H 01 S 3/08 H 01 S 3/133 |
| | -- | | |
| X | DE - A1 - 3 410 729 (LICENTIA) | 1,6,7 | |
| A | * Gesamt * | 2,3,10, 11,13, 14 | |
| | -- | | |
| X | DE - A1 - 3 442 188 (ANT) | 1,6 | |
| A | * Gesamt * | 3,7,10, 11,13, 15 | |
| | -- | | |
| X | US - A - 4 485 474 (OSTERWALDER) | 1,2 | |
| A | * Fig. 1,2; Spalte 1, Zeile 62 - Spalte 2, Zeile 24 * | 10,11, 13 | RECHERCHIERTE SACHGEBIETE (Int. Cl.4) |
| X | EP - A2 - 0 206 661 (SHARP) | 1 | H 01 S |
| A | * Fig. 2,3,1; Seite 2, Zeilen 18-29; Seite 3, Zeile 29 - Seite 4, Zeile 4; Seite 6, Zeilen 3-9; Seite 7, Zeilen 1-20 * | 3,67 | H 01 L G 11 B |
| | -- | | |
| D,X | EP - A1 - 0 204 224 (SIEMENS) | 10,11, 12,14, 15 | |
| D,A | * Fig. 1,2,4; Ansprüche 25,27,28, 30,32; Spalte 4, Zeilen 5-37; Spalte 8, Zeile 48 - Spalte 9, Zeile 4 * | 1,13 | |
| | -- | | |

Der vorliegende Recherchenbericht wurde für alle Patentansprüche erstellt.

| Recherchenort | Abschlußdatum der Recherche | Prüfer |
|---|---|---|
| WIEN | 17-10-1988 | HEINICH |

Europäisches
Patentamt

**EUROPÄISCHER RECHERCHENBERICHT**

Nummer der Anmeldung

−2−
EP 88111256.9

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | US - A - 4 583 227 (KIRKBY)<br><br>* Fig. 3,4; Spalte 4, Zeile 50 - Spalte 5, Zeile 8; Spalte 6, Zeilen 29-47 *<br><br>-- | 1,6, 10,11, 15 | |
| A | GB - A - 2 146 841 (HITACHI)<br><br>* Fig. 1,4,8; Zusammensetzung *<br><br>---- | 1,13, 14 | |

RECHERCHIERTE
SACHGEBIETE (Int. Cl.4)

Der vorliegende Recherchenbericht wurde für alle Patentansprüche erstellt.

| Recherchenort | Abschlußdatum der Recherche | Prüfer |
|---|---|---|
| WIEN | 17-10-1988 | HEINICH |